# EUROPEAN PATENT SPECIFICATION

(11) **EP 2 915 198 B1**
(45) Date of publication and mention of the grant of the patent: **17.10.2018**
(21) Application number: 13783601.1
(22) Date of filing: 29.10.2013
(51) Int. Cl.: H01L 33/58, F21K 99/00, F21Y 103/00, H01L 25/075, F21Y 113/20

(54) **LIGHT EMITTING MODULE, LIGHTING DEVICE, AND LIGHT BOX COMPRISING THE LIGHT EMITTING MODULE**
LICHTEMITTIERENDES MODUL UND BELEUCHTUNGSVORRICHTUNG SOWIE LEUCHTKASTEN MIT DEM LICHTEMITTIERENDEN MODUL
MODULE ÉLECTROLUMINESCENT, ET DISPOSITIF D'ÉCLAIRAGE ET BOÎTIER LUMINEUX COMPRENANT LE MODULE ÉLECTROLUMINESCENT

(30) Priority: 30.10.2012 CN 201210426091
(43) Date of publication of application: 09.09.2015
(73) Proprietor: OSRAM GmbH, 80807 München (DE)
(72) Inventor: MING, Yusheng, Shenzhen Guangdong 518053 (CN); HE, Yuanyuan, Shenzhen Guangdong 518053 (CN); FENG, Yaojun, Shenzhen Guangdong 518053 (CN); OU, Zhijun, Shenzhen Guangdong 518053 (CN)
(86) International application number: PCT/EP2013/072616
(87) International publication number: WO 2014/067949

(56) References cited:
- WO-A1-2010/108761
- WO-A1-2010/133772
- JP-A- 2007 227 679
- US-A1- 2003 053 310
- US-A1- 2004 170 018
- US-A1- 2007 030 676
- US-A1- 2011 103 070

## Description

### Technical Field

The present invention relates to a light emitting module, and a lighting device and a light box comprising the light emitting module.

### Background Art

An LED light emitting module plays a leading role in the current field of illumination because it has advantages of energy saving and high efficiency. Retrofit lamps using an LED as a light source have been widely used instead of fluorescent lamps in various occasions with the development of illumination technology. For example, in the advertisement industry, it is necessary to mount a plurality of LED light emitting modules in a linear arrangement in an electronic advertising panel or signage light to achieve a predetermined illuminating pattern, wherein there is an inevitable distance between two adjacent light emitting modules.

In the prior art, the respective light sources of a light emitting module are usually mounted with identical lenses so as to improve illuminating efficiency. However, such uniform design causes that each light emitting module uniformly irradiates only in a direction along an optical axis while a dark area is present in a surface on which the light emitting module is mounted, in particular, a shading area is present in a middle area between two adjacent light emitting modules. This will limit and affect the illuminating effect of the whole illuminating device. Therefore, there is a demand for further modifying a prior light emitting module, in particular, an LED light emitting module to meet users' requirements.

WO 2010/133772A1 shows further prior art in the field of LED light source elements.

### Summary of the invention

To solve the above technical problem, the present invention provides a novel light emitting module according to appended independent claim 1. The light emitting module has the advantages of simple structure, efficient energy saving, and large illumination range.

According to the present invention, there is provided a light emitting module comprising comprises a center region and an edge region, at least one first light source arranged in the edge region on one plane of the circuit board, and at least one first optical device assigned to the respective first light sources, wherein light emitted through each of the first optical device towards a side space beyond the edge region of the circuit board is more than light emitted from the same first optical device towards the center region of the circuit board, wherein a light flux towards the side space is greater than thereof towards a center region of the light emitting module. The light flux through each first optical device towards the side space is greater than thereof towards the center region of the circuit board. Therefore, the asymmetrical illuminating effect is realized.

According to the present invention, the first optical device is a first lens, the first lens has a first axis and a second axis perpendicular to the first axis, which define a base plane of the first lens, and a third axis perpendicular to the base plane of the first lens. The first lens comprises an emitting surface, the emitting surface forms a first curve on a vertical plane of the first lens passing through the first axis of the first lens and the third axis of the first lens, and the first curve is asymmetric about the third axis of the first lens. In a traditional light emitting module, a lens mounted on a circuit board is usually, for example, a spherical lens designed symmetrically.

Such a lens generally has a single optical axis, and light emitted through the lens is mostly extended in a direction perpendicular to the circuit board, which can only achieve a uniform light spot centered around the optical axis. The light emitting module according to the present invention has a lens designed asymmetrically, and light emitted from the light source can be refracted by the asymmetric lens towards a desired illumination region, i.e. a side external space outside the light emitting module. The emitted light is respectively extended along, for example, two optical axes so as to form a targeted light spot covering a particular region. Therefore, the side external space outside the light emitting module has a higher luminance than the traditional light emitting module.

According to the present invention, the first optical device comprises a first emitting surface facing the center of the circuit board and a second emitting surface facing the edge of the circuit board, and the first emitting surface and the second emitting surface are smoothly connected to form an asymmetrical arched light emitting surface. Incident light from the light source is divided by the first and second emitting surfaces into two parts of light emitted towards different directions, and light emitted through the second emitting surface is irradiated towards a side space outside the light emitting module, and thereby an illumination area of the light emitting module can be increased in a side direction.

According to the present invention, the first emitting surface forms a second curve on the vertical plane of the first lens, the second emitting surface forms a third curve on the vertical plane of the first lens, the second curve and the third curve are smoothly connected to form the first curve.

According to the present invention, the first incident surface comprises a first incident surface, an accommodating cavity for accommodating the light source is defined by a first incident surface of the first optical device and the circuit board. Preferably, the first incident surface is a spherical surface. Incident light from the light source can be obtained as efficiently as possible by the first optical device so designed.

According to the present invention, at least one second light source and at least one second optical device assigned to the respective second light source are arranged in the center region of the circuit board.

According to the present invention, the second optical device is a second lens, the second lens has a first axis and a second axis perpendicular to the first axis, which define a base plane of the second lens, and a third axis perpendicular to the base plane of the second lens. The second lens comprises an fourth emitting surface, the fourth emitting surface forms a fourth curve on a vertical plane of the second lens passing through the first axis of the second lens and the third axis of the second lens, and the fourth curve is symmetric about the third axis of the second lens.

In a preferred design according to the present invention, there is a first angle between the second curve and the first axis of the first lens, there is a second angle between he third curve and the first axis of the first lens, and the first angle is greater than the second angle. Thus, it can be ensured that most of light from the light source is emitted towards a side direction of the light emitting module through the second emitting surface, and a small amount of the light is emitted towards a central direction of the light emitting module.

In a preferred design according to the present invention, the second curve and the third curve are spline curves. The shapes of the first and second emitting surfaces may be adjusted according to application requirements.

In a preferred design according to the present invention, the first light source and the second light source are the same light source. In additional preferably, the fourth emitting surface of the second lens has a spherical profile. Thus, it can be ensured that the central region of the light emitting module also has emitted light, in particular, light emitted in a direction perpendicular to the circuit board, and thereby luminance of the light emitting module and uniformity of light emitted therefrom can be improved.

In another preferred design according to the present invention, a plurality of the first optical devices are arranged around the second optical device. The first optical devices arranged in a ring shape can achieve a circular light spot having a large side covering area, the second optical device arranged in the center of the circular shape can achieve a central, uniform light spot, and a uniform light distribution pattern having a large area can be achieved by superimposing the two light spots.

In another preferred design according to the present invention, the second optical device is located at the center of an array of the plurality of first optical devices. The design can further improve the luminance of the light emitting module and allows the light distribution pattern achieved by the light emitting module to be more uniform.

The present invention further relates to a lighting device characterized in comprising at least two light emitting modules described above, two adjacent light emitting modules being electrically connected to each other and defining a middle region therebetween, wherein light beams emitted from the two adjacent light emitting modules are superposed in the middle region. Since the light emitting module can irradiate particularly towards an external space thereof, formation of a dark area between two adjacent light emitting modules can be avoided.

In another preferred design according to the present invention, a plurality of the light emitting modules form a linear array. The lighting device can be configured in a different pattern and obtain a corresponding light pattern in an operation state. A shade or black spot caused due to nonuniformity of light distribution will hardly occur in the light pattern.

Furthermore, the present invention relates to a light box comprising a housing which is capable of transmitting light through at least one side thereof, characterized in further comprising a lighting device described above, wherein the lighting device is mounted in the housing. The light box can be used as an advertising light box or decorative light box and has a uniform illumination effect.

In another preferred design according to the present invention, the side surface capable of transmitting light is provided with an optical layer. Thus, the illumination effect of the light box can be improved, for example, an effect such as diffusion or scattering can be achieved according to the actual situation.

It should be understood that both the foregoing brief description and the following detailed description are exemplary and explanatory only and are intended to provide further explanation of the invention as claimed.

### Brief Description of the Drawings

The drawings constitute a portion of the Description for further understanding of the present invention. These drawings illustrate the embodiments of the present invention and explain the principle of the present invention together with the Description. In the drawings, the same part is represented by the same reference sign. In the drawings,
Fig. 1 illustrates a sectional view of a first embodiment of a light box 30 according to the present invention in which a plurality of light emitting modules 10 according to the present invention are mounted;
Fig. 2 illustrates a light distribution pattern of the first embodiment; and
Fig. 3 illustrates a luminance curve of the first embodiment.

### Detailed Description of the Embodiments

In the following detailed description, reference is made to the accompanying drawings, which form a part hereof, and in which is shown by way of illustration specific embodiments in which the invention may be practiced. In this regard, directional terminology, such as "top", "bottom", "inside", "outside", etc., is used reference to the orientation of the Figure(s) being described. Because components of embodiments can be positioned in a number of different orientations, the directional terminology is used for purposes of illustration and is in no way limiting. It is to be understood that other embodiments may be utilized and structural or logical changes may made without departing from the scope of the present invention. The following detailed description, therefore, is not to be taken in a limiting sense, and the scope of the present invention is defined by the appended claims.

It is to be understood that the features of the various exemplary embodiments described herein may be combined with each other, unless specifically noted otherwise.

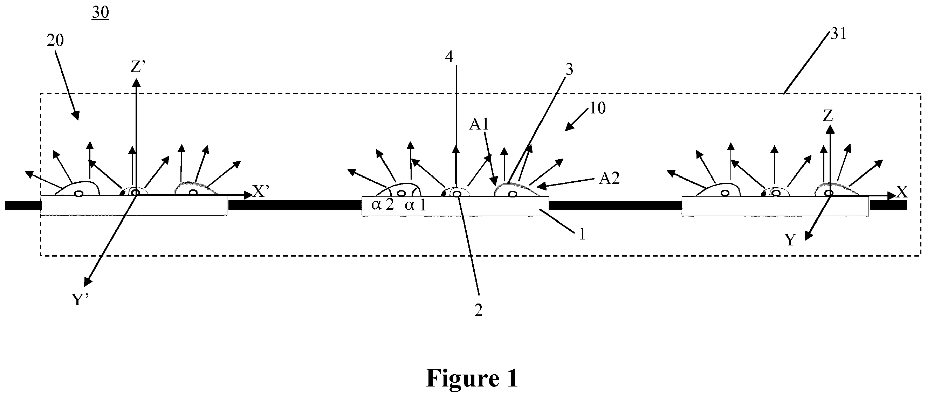

Fig. 1 illustrates a sectional view of a first embodiment of a light box 30 according to the present invention, the light box 30 comprises a housing 31 and a lighting device 20 mounted therein, and a housing wall of the housing 31 facing the lighting device 20 is a side surface capable of transmitting light. The lighting device 20 is formed by connecting three light emitting modules 10 arranged linearly, wherein there is a certain distance between two adjacent light emitting modules 10.

The light emitting module 10 comprises a circuit board 1 and three light sources 2 arranged on the circuit board 1, wherein a light source 2 in the center is provided with a second lens 4, and two light sources 2 in an edge region are each provided with a first lens 3. The first lens 3 has a profile designed asymmetrically, and light emitted from the respective light source 2 is mostly emitted through the first lens 3 provided thereto towards a side external space beyond the edge region of the light emitting module 10. The term "a side external space beyond the edge region" refers to a space between two adjacent light emitting modules 10 and may be called "a middle region" R for short. Since there is no light source in the middle region, luminance of the middle region depends only on a flux of light emitted from the adjacent light emitting modules 10 towards the middle region.

The first lens 3 has a first axis and a second axis Y perpendicular to the first axis X, which define a base plane X-Y of the first lens 3, and a third axis Z perpendicular to the base plane X-Y. The first lens 3 comprises an emitting surface, the emitting surface forms a first curve on a vertical plane X-Z of the first lens 3 passing through the first axis X and the third axis Z, and the first curve is asymmetric about the third axis Z. The first emitting surface A1 forms a second curve on the vertical plane X-Z, the second emitting surface A2 forms a third curve on the vertical plane X-Z, the second curve and the third curve are smoothly connected to form the first curve.

The first lens 3 is particularly designed to have a first emitting surface A1 facing the center of the circuit board 1 and a second emitting surface A2 facing the middle region so that light from the light source 2 can be emitted towards a predetermined region, i.e., the middle region. The first emitting surface A1 forming a first angle α1 with the circuit board 1 has a small area, and incident light from the light **source** 2 is emitted towards the center of the circuit board 1 through the first emitting surface A1. The second emitting surface A2 forming a second angle α2 with the circuit board 1 has a large area, and incident light from the light source 2 is emitted towards the middle region R outside the circuit board through the second emitting surface A2. The first emitting surface A1 and the second emitting surface A2 each of which can be, for example, defined in cross section by a spline curve are smoothly connected to thereby form an asymmetric arched light emitting surface of the first lens 3.

Moreover, incident surface of the first lens 3 can be designed as a spherical surface defining, with the circuit board 1, an accommodating cavity for accommodating the light source 2 so that incident light from the light source 2 can be obtained as efficiently as possible.

The second lens 4 mounted on the center of the circuit board 1 is designed as a spherical lens having a symmetrical profile. The second lens 4 has a first axis X' and a second axis Y' perpendicular to the first axis X', which define a base plane X'-Y' of the second lens 4, and a third axis Z' perpendicular to the base plane X'-Y'. The second lens 4 comprises an fourth emitting surface, the fourth emitting surface forms a fourth curve on a vertical plane X'-Z' of the second lens 4 passing through the first axis X' and the third axis Z', and the fourth curve is symmetric about the third axis Z'.

The second lens 4 is not only fixed on the center of the circuit board 1 but also located in the center of two first lenses 3 so that a central region of the light emitting module 10 also has enough emitted light. A light beam emitted through the second lens 4 and light beams emitted from the edge region of circuit board 1 through the first emitting surfaces A1 of the first lenses 4 jointly ensure that a central region of a light distribution pattern of the light emitting module 10 has enough luminance. Light beams emitted from the edge region of circuit board 1 through the second emitting surfaces A2 of the first lenses 4 jointly ensure that an edge region of the light distribution pattern of the light emitting module 10 has enough luminance. Thus, a uniform light distribution pattern with no dark area can be achieved by the lighting device 20 composed of three light emitting modules 10.

Preferably, the side surface capable of transmitting light is provided with an optical layer. Thus, the illuminating effect of the light box 30 can be improved, for example, an effect such as diffusion or scattering can be achieved according to the actual situation.

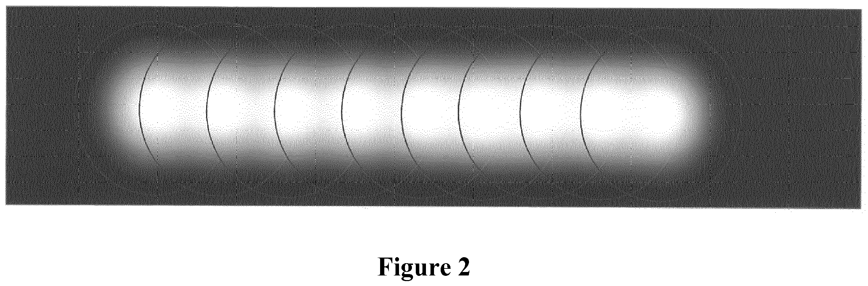

For example, when the light emitting module 10 is spaced by a distance of 40 mm to 60 mm from the side surface of the housing 31 that is capable of transmitting light, a uniform and continuous strip-shaped light spot can be formed, as shown in Fig. 2, on the side surface capable of transmitting light.

In an embodiment not shown, two or more light sources provided with the second lenses can be arranged in the central region of the light emitting module to improve the luminance of the light emitting module. Accordingly, three or more light sources provided with the first lenses are arranged in the edge region of the light emitting module around the second lenses so as to further improve the luminance of the middle region between the light emitting modules. These lenses are spaced uniformly from one anther, and preferably form a circular array.

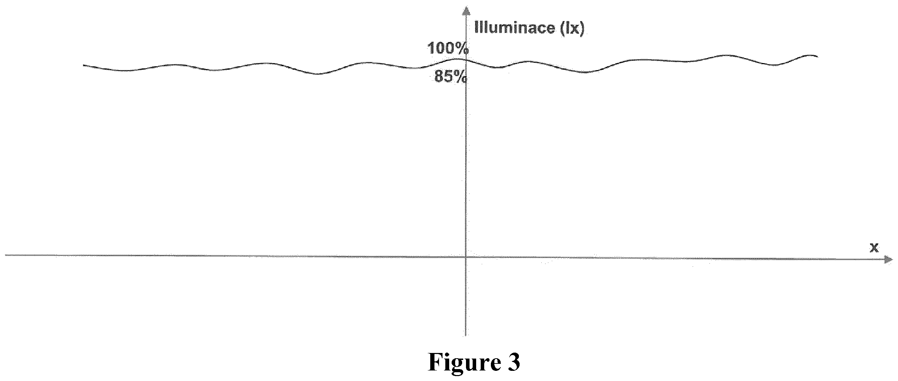

Fig. 3 illustrates a luminance curve of the first embodiment in Fig. 1. As can be seen from the figure, the light box 30 according to the present invention has a high luminance (which can reach 85%) which is distributed uniformly on an object to be illuminated.

In addition, while a particular feature or aspect of an embodiment of the invention may have been disclosed with respect to only one of several implementations, such feature or aspect may be combined with one or more other features or aspects of the other implementations as may be desired and advantageous for any given or particular application.

The above is merely preferred embodiments of the present invention but not to limit the present invention. For the person skilled in the art, the present invention may have various alterations and changes.

### List of reference numerals

- 1: circuit board
- 2: light source
- 3: first optical device/first lens
- 4: second optical device/second lens
- 10: light emitting module
- 20: lighting device
- 30: light box
- 31: housing
- A1: first emitting surface
- A2: second emitting surface
- α1: first angle
- α2: second angle
- R: middle region
- X: first axis of the first optical device
- X': first axis of the second optical device
- Y: second axis of the first optical device
- Y': second axis of the second optical device
- Z: third axis of the first optical device
- Z': third axis of the second optical device
- X-Y: base plane of the first optical device
- X'-Y': base plane of the second optical device
- X-Z: vertical plane of the first optical device
- X'-Z': vertical plane of the second optical device
- X'-Z': vertical plane of the second optical device

## Claims

1. A light emitting module (10) comprising a circuit board (1) which comprises a center region and an edge region, at least one first light source (2) arranged in the edge region on one plane of the circuit board (1), and at least one first optical device (3) assigned to the respective first light sources (2), wherein light emitted through the first optical device (3) or each of the first optical devices (3) assigned to the respective first light sources (2) towards a side space beyond the edge region of the circuit board (1) is more than light emitted from the same first optical device (3) towards the center region of the circuit board (1), wherein the first optical device (3) is a first lens, the first lens has a first axis (X) and a second axis (Y) perpendicular to the first axis (X), which define a base plane (X-Y) of the first lens, and a third axis (Z) perpendicular to the base plane (X-Y) of the first lens and the first lens comprises an emitting surface, the emitting surface forms a first curve on a vertical plane (X-Z) of the first lens passing through the first axis (X) of the first lens and the third axis (Z) of the first lens and the first curve is asymmetric about the third axis (Z) of the first lens and the first lens comprises a first emitting surface (A1) facing the center of the circuit board (1) and a second emitting surface (A2) facing the edge of the circuit board (1), an accommodating cavity for accommodating the light source (2) is defined by a first incident surface of the first lens and the circuit board (1).
**characterized in that**
the first emitting surface (A1) and the second emitting surface (A2) are smoothly connected to form an asymmetrical arched light emitting surface and that at least one second light source and at least one second optical device (4) assigned to the respective second light source are arranged in the center region of the circuit board (1), the second optical device (4) is a second lens, the second lens has a first axis (X') and a second axis (Y') perpendicular to the first axis (X'), which define a base plane (X'-Y') of the second lens, and a third axis (Z') perpendicular to the base plane (X'-Y') of the second lens and the second lens comprises an fourth emitting surface, the fourth emitting surface forms a fourth curve on a vertical plane (X'-Z') of the second lens passing through the first axis (X') of the second lens and the third axis (Z') of the second lens, and the fourth curve is symmetric about the third axis (Z') of the second lens.

2. The light emitting module (10) according to claim 1, **characterized in that** the first emitting surface (A1) forms a second curve on the vertical plane (X-Z) of the first lens, the second emitting surface (A2) forms a third curve on the vertical plane (X-Z) of the first lens, the second curve and the third curve are smoothly connected to form the first curve.

3. The light emitting module (10) according to claim 2, **characterized in that** there is a first angle (α1) between the second curve and the first axis (X) of the first lens, there is a second angle (α2) between the third curve and the first axis (X) of the first lens, and the first angle (α1) is greater than the second angle (α2).

4. The light emitting module (10) according to any of claims 2 to 3, **characterized in that** the second curve and the third curve are spline curves.

5. The light emitting module (10) according to any of claims 1 to 4, **characterized in that** the first incident surface is a spherical surface.

6. The light emitting module (10) according to any of claims 1 to 5, **characterized in that** the first light source (2) and the second light source are the same light source.

7. The light emitting module (10) according to any of claims 1 to 5, **characterized in that** the fourth emitting surface of the second lens has a spherical profile.

8. The light emitting module (10) according to any of claims 1 to 7, **characterized in that** a plurality of the first lenses (3) are arranged around the second optical device (4).

9. The light emitting module (10) according to any of claims 1 to 8, **characterized in that** the second optical device (4) is located at the center of an array of the plurality of first optical devices (3).

10. A lighting device (20) **characterized in** comprising at least two light emitting modules (10) according to any one of claims 1 to 9, two adjacent light emitting modules (10) being electrically connected to each other and defining a middle region (R) therebetween, wherein light beams emitted from the two adjacent light emitting modules (10) are superposed in the middle region (R).

11. The lighting device (20) according to claim 10, **characterized in that** a plurality of the light emitting modules (10) form a linear array.

12. A light box (30) comprising a housing (31) which is capable of transmitting light through at least one side thereof, **characterized in** further comprising a lighting device (20) according to claim 10 or 11, wherein the lighting device (20) is mounted in the housing (31).

## Patentansprüche

1. Lichtemittierendes Modul (10), umfassend eine Schaltungsplatine (1), welche eine Zentrumsregion und eine Kantenregion, mindestens eine in der Kantenregion auf einer Ebene der Schaltungsplatine (1) angeordnete erste Lichtquelle (2), und mindestens eine erste optische Vorrichtung (3), die den jeweiligen ersten Lichtquellen (2) zugeordnet sind, umfasst, wobei Licht, das durch die erste optische Vorrichtung (3) oder jede der ersten optischen Vorrichtungen (3), die den jeweiligen ersten Lichtquellen (2) zugeordnet sind, zu einem Seitenraum jenseits der Kantenregion der Schaltungsplatine (1) emittiert wird, stärker als Licht ist, das von derselben ersten optischen Vorrichtung (3) zu der Zentrumsregion der Schaltungsplatine (1) emittiert wird, wobei die erste optische Vorrichtung (3) eine erste Linse ist, die erste Linse eine erste Achse (X) und eine zu der ersten Achse (X) senkrechte zweite Achse (Y), welche eine Basisebene (X-Y) der ersten Linse definieren, und eine zu der Basisebene (X-Y) senkrechte dritte Achse (Z) der ersten Linse aufweist und die erste Linse eine emittierende Oberfläche umfasst, die emittierende Oberfläche eine erste Kurve auf einer vertikalen Ebene (X-Z) der ersten Linse, durch die erste Achse (X) der ersten Linse und die dritte Achse (Z) der ersten Linse hindurchgehend, ausbildet und die erste Kurve um die dritte Achse (Z) der ersten Linse herum asymmetrisch ist und die erste Linse eine dem Zentrum der Schaltungsplatine (1) zugewandte erste emittierende Oberfläche (A1) und eine der Kante der Schaltungsplatine (1) zugewandte zweite emittierende Oberfläche (A2) umfasst, wobei eine Aufnahmekavität zum Aufnehmen der Lichtquelle (2) durch eine erste Einfallsoberfläche der ersten Linse und die Schaltungsplatine (1) definiert ist,
**dadurch gekennzeichnet, dass**
die erste emittierende Oberfläche (A1) und die zweite emittierende Oberfläche (A2) sanft miteinander verbunden sind, um eine asymmetrisch bogenförmige lichtemittierende Oberfläche auszubilden und dass mindestens eine zweite Lichtquelle und mindestens eine zweite optische Vorrichtung (4), die der jeweiligen zweiten Lichtquelle zugeordnet ist, in der Zentrumsregion der Schaltungsplatine (1) angeordnet sind, wobei die zweite optische Vorrichtung (4) eine zweite Linse ist, die zweite Linse eine erste Achse (X') und eine zu der ersten Achse (X') senkrechte zweite Achse (Y'), welche eine Basisebene (X'-Y') der zweiten Linse definieren, und eine zu der Basisebene (X'-Y') senkrechte dritte Achse (Z') der zweiten Linse aufweist und die zweite Linse eine vierte emittierende Oberfläche umfasst, die vierte emittierende Oberfläche eine vierte Kurve auf einer vertikalen Ebene (X'-Z') der zweiten Linse, durch die erste Achse (X') der zweiten Linse und die dritte Achse (Z') der zweiten Linse hindurchgehend, ausbildet und die vierte Kurve um die dritte Achse (Z') der zweiten Linse herum symmetrisch ist.

2. Lichtemittierendes Modul (10) nach Anspruch 1, **dadurch gekennzeichnet, dass** die erste emittierende Oberfläche (A1) eine zweite Kurve auf der vertikalen Ebene (X-Z) der ersten Linse ausbildet, die zweite emittierende Oberfläche (A2) eine dritte Kurve auf der vertikalen Ebene (X-Z) der ersten Linse ausbildet, die zweite Kurve und die dritte Kurve sanft miteinander verbunden sind, um die erste Kurve auszubilden.

3. Lichtemittierendes Modul (10) nach Anspruch 2, **dadurch gekennzeichnet, dass** es einen ersten Winkel (α1) zwischen der zweiten Kurve und der ersten Achse (X) der ersten Linse gibt, es einen zweiten Winkel (α2) zwischen der dritten Kurve und der ersten Achse (X) der ersten Linse gibt und der erste Winkel (α1) größer als der zweite Winkel (α2) ist.

4. Lichtemittierendes Modul (10) nach einem der Ansprüche 2 oder 3, **dadurch gekennzeichnet, dass** die zweite Kurve und die dritte Kurve Spline-Kurven sind.

5. Lichtemittierendes Modul (10) nach einem der Ansprüche 1 bis 4, **dadurch gekennzeichnet, dass** die erste Einfallsoberfläche eine sphärische Oberfläche ist.

6. Lichtemittierendes Modul (10) nach einem der Ansprüche 1 bis 5, **dadurch gekennzeichnet, dass** die erste Lichtquelle (2) und die zweite Lichtquelle dieselbe Lichtquelle sind.

7. Lichtemittierendes Modul (10) nach einem der Ansprüche 1 bis 5, **dadurch gekennzeichnet, dass** die vierte emittierende Oberfläche der zweiten Linse ein sphärisches Profil aufweist.

8. Lichtemittierendes Modul (10) nach einem der Ansprüche 1 bis 7, **dadurch gekennzeichnet, dass** mehrere der ersten Linsen (3) um die zweite optische Vorrichtung (4) herum angeordnet sind.

9. Lichtemittierendes Modul (10) nach einem der Ansprüche 1 bis 8, **dadurch gekennzeichnet, dass** sich die zweite optische Vorrichtung (4) in dem Zentrum eines Arrays der mehreren ersten optischen Vorrichtungen (3) befindet.

10. Beleuchtungsvorrichtung (20), **dadurch gekennzeichnet, dass** sie mindestens zwei lichtemittierende Module (10) nach einem der Ansprüche 1 bis 9 umfasst, wobei zwei benachbarte lichtemittierende Module (10) elektrisch miteinander verbunden sind und eine Mittenregion (R) dazwischen definieren, wobei von den zwei benachbarten lichtemittierenden Modulen (10) emittierte Lichtstrahlen in der Mittenregion (R) überlagert werden.

11. Beleuchtungsvorrichtung (20) nach Anspruch 10, **dadurch gekennzeichnet, dass** mehrere der lichtemittierenden Module (10) ein lineares Array ausbilden.

12. Lichtkiste (30), umfassend ein Gehäuse (31), welches fähig ist zum Transmittieren von Licht durch mindestens eine Seite davon, **dadurch gekennzeichnet, dass** sie ferner eine Beleuchtungsvorrichtung (20) nach Anspruch 10 oder 11 umfasst, wobei die Beleuchtungsvorrichtung (20) in dem Gehäuse (31) montiert ist.

## Revendications

1. Module électroluminescent (10) comprenant une carte de circuit (1) qui comprend une région centrale et une région de bord, au moins une première source de lumière (2) qui est agencée dans la région de bord sur un plan de la carte de circuit (1), et au moins un premier dispositif optique (3) qui est attribué aux premières sources de lumière respectives (2), dans lequel la lumière qui est émise par l'intermédiaire du premier dispositif optique (3) ou de chacun des premiers dispositifs optiques (3) qui sont attribués aux premières sources de lumière respectives (2) en direction d'un espace latéral au-delà de la région de bord de la carte de circuit (1) est plus forte que la lumière qui est émise depuis le même premier dispositif optique (3) en direction de la région centrale de la carte de circuit (1), dans lequel le premier dispositif optique (3) est une première lentille, la première lentille comporte un premier axe (X) et un deuxième axe (Y) perpendiculaire au premier axe (X), lesquels axes définissent un plan de base (X-Y) de la première lentille, et un troisième axe (Z) perpendiculaire au plan de base (X-Y) de la première lentille, et la première lentille comprend une surface d'émission, la surface d'émission forme une première courbe sur un plan vertical (X-Z) de la première lentille qui passe par le premier axe (X) de la première lentille et par le troisième axe (Z) de la première lentille, et la première courbe est asymétrique par rapport au troisième axe (Z) de la première lentille, et la première lentille comprend une première surface d'émission (A1) qui fait face au centre de la carte de circuit (1) et une deuxième surface d'émission (A2) qui fait face au bord de la carte de circuit (1), une cavité de logement pour loger la source de lumière (2) est définie par une première surface d'incidence de la première lentille et par la carte de circuit (1),
**caractérisé en ce que** :
la première surface d'émission (A1) et la deuxième surface d'émission (A2) sont connectées sans discontinuités de manière à ce qu'elles forment une surface d'émission de lumière en forme d'arc asymétrique et **en ce qu'**au moins une seconde source de lumière et au moins un second dispositif optique (4) qui est attribué à la seconde source de lumière respective sont agencés dans la région centrale de la carte de circuit (1), le second dispositif optique (4) est une seconde lentille, la seconde lentille comporte un premier axe (X') et un deuxième axe (Y') perpendiculaire au premier axe (X'), lesquels axes définissent un plan de base (X'-Y') de la seconde lentille, et un troisième axe (Z') perpendiculaire au plan de base (X'-Y') de la seconde lentille, et la seconde lentille comprend une quatrième surface d'émission, la quatrième surface d'émission forme une quatrième courbe sur un plan vertical (X'-Z') de la seconde lentille qui passe par le premier axe (X') de la seconde lentille et par le troisième axe (Z') de la seconde lentille, et la quatrième courbe est symétrique par rapport au troisième axe (Z') de la seconde lentille.

2. Module électroluminescent (10) selon la revendication 1, **caractérisé en ce que** la première surface d'émission (A1) forme une deuxième courbe sur le plan vertical (X-Z) de la première lentille, la deuxième surface d'émission (A2) forme une troisième courbe sur le plan vertical (X-Z) de la première lentille, la deuxième courbe et la troisième courbe sont connectées sans discontinuités de manière à ce qu'elles forment la première courbe.

3. Module électroluminescent (10) selon la revendication 2, **caractérisé en ce qu'**un premier angle (α1) est formé entre la deuxième courbe et le premier axe (X) de la première lentille, un second angle (α2) est formé entre la troisième courbe et le premier axe (X) de la première lentille, et le premier angle (α1) est plus grand que le second angle (α2).

4. Module électroluminescent (10) selon l'une quelconque des revendications 2 à 3, **caractérisé en ce que** la deuxième courbe et la troisième courbe sont des courbes spline.

5. Module électroluminescent (10) selon l'une quelconque des revendications 1 à 4, **caractérisé en ce que** la première surface d'incidence est une surface sphérique.

6. Module électroluminescent (10) selon l'une quelconque des revendications 1 à 5, **caractérisé en ce que** la première source de lumière (2) et la seconde source de lumière sont la même source de lumière.

7. Module électroluminescent (10) selon l'une quelconque des revendications 1 à 5, **caractérisé en ce que** la quatrième surface d'émission de la seconde lentille présente un profil sphérique.

8. Module électroluminescent (10) selon l'une quelconque des revendications 1 à 7, **caractérisé en ce que** les lentilles d'une pluralité des premières lentilles (3) sont agencées autour du second dispositif optique (4).

9. Module électroluminescent (10) selon l'une quelconque des revendications 1 à 8, **caractérisé en ce que** le second dispositif optique (4) est situé au niveau du centre d'un réseau de la pluralité de premiers dispositifs optiques (3) .

10. Dispositif d'éclairage (20) **caractérisé en ce qu'**il comprend au moins deux modules électroluminescents (10) selon l'une quelconque des revendications 1 à 9, deux modules électroluminescents adjacents (10) étant connectés électriquement l'un à l'autre et définissant une région intermédiaire (R) entre eux, dans lequel des faisceaux lumineux qui sont émis depuis les deux modules électroluminescents adjacents (10) sont superposés dans la région intermédiaire (R).

11. Dispositif d'éclairage (20) selon la revendication 10, **caractérisé en ce que** les modules d'une pluralité des modules électroluminescents (10) forment un réseau linéaire.

12. Boîtier lumineux (30) comprenant une enceinte (31), laquelle dispose de la capacité de transmettre la lumière au travers d'au moins l'un de ses côtés, **caractérisé en ce qu'**il comprend en outre un dispositif d'éclairage (20) selon la revendication 10 ou 11, dans lequel le dispositif d'éclairage (20) est monté dans l'enceinte (31).
